# FASCICULE DE BREVET EUROPEEN

(11) **EP 1 540 721 B1**
(45) Date de publication et mention de la délivrance du brevet: **03.05.2006**
(21) Numéro de dépôt: 03780270.9
(22) Date de dépôt: 19.09.2003
(51) Int. Cl.: H01L 21/445

(54) **Procédé de fabrication d'électrodes sur un composé II-VI semiconducteur**
Verfahren zur Herstellung von Elektroden auf einem II-VI-Verbindungshalbleitermaterial
Method for the production of electrodes on a II-VI semiconducting compound

(30) Priorité: 20.09.2002 FR 0211675
(43) Date de publication de la demande: 15.06.2005
(73) Titulaire: COMMISSARIAT A L'ENERGIE ATOMIQUE, 75752 Paris Cédex 15 (FR)
(72) Inventeur: PETROZ, Gérard, F-38330 Montbonnot (FR)
(74) Mandataire: Poulin, Gérard
(86) Numéro de dépôt international: PCT/FR2003/050057
(87) Numéro de publication internationale: WO 2004/027854

(56) Documents cités:
- EP-A- 0 674 348
- FR-A- 1 143 213
- US-A- 6 091 070
- E. JANIK, R. TRIBOULET: "Ohmic contacts to p-type cadmium telluride and cadmium mercury telluride" JOURNAL OF PHYSICS D : APPLIED PHYSICS, vol. 16, - 1983 pages 2333-2340, XP002250667 cité dans la demande
- GOSTILO V ET AL: "Technological aspects of development of pixel and strip detectors based on CdTe and CdZnTe" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, vol. 460, no. 1, 11 mars 2001 (2001-03-11), pages 27-34, XP004230589 ISSN: 0168-9002

## Description

### DOMAINE TECHNIQUE

La présente invention concerne un procédé de fabrication d'électrodes sur un matériau semi-conducteur de type II-VI ou sur un composé de ce matériau.

Elle s'applique notamment aux détecteurs de rayonnements X ou gamma et, plus particulièrement
- aux blocs de détecteurs individuels, susceptibles d'être juxtaposés dans une matrice de détection, et
- aux détecteurs monolithiques, comportant de multiples électrodes sur une face (pixellisation) et une électrode de polarisation sur une autre face.

L'invention concerne en particulier la fabrication d'électrodes sur les détecteurs réalisés à partir de matériaux semi-conducteurs de type II-VI tels que CdZnTe, CdTe, CdTe:Cl, CdTeSe:Cl, CdZnTe:Cl, CdTe:In, CdTe:In, CdZnTe:In et CdHgTe par exemple.

Ces semi-conducteurs à base de tellure et de cadmium peuvent être obtenus par exemple par une méthode de croissance de type Bridgman ou THM et présentent, comme caractéristique majeure, une très haute résistivité électrique (supérieur à 10⁹Ω.cm) qui est indispensable à la réalisation de dispositifs de spectrométrie X ou gamma dédiés à l'imagerie médicale, industrielle ou scientifique.

Le procédé objet de l'invention est directement utilisable industriellement à cause de sa simplicité, de son adaptation aux produits courants de l'industrie des semi-conducteurs (résines positives) et de son coût modéré. Il est particulièrement adapté aux détecteurs X ou gamma mais ne se limite pas à cette application.

### ETAT DE LA TECHNIQUE ANTERIEURE

On connaît différents types de détecteurs de rayonnement parmi lesquels figurent les détecteurs à gaz, les détecteurs à scintillateurs et les détecteurs à semi-conducteurs. Ces derniers présentent l'avantage de posséder un fort numéro atomique permettant d'absorber un maximum de photons incidents pour une épaisseur minimale de matériau.

Ces détecteurs à semi-conducteurs sont généralement de forme parallélépipédique et sont découpés dans une tranche de lingot, comportant au moins deux faces parallèles sur lesquelles on réalise les contacts électriques permettant de polariser les détecteurs et de recueillir les signaux électriques produits par les rayonnements incidents.

Les contacts électriques ne doivent pas modifier notablement le comportement du détecteur correspondant et doivent par conséquent avoir une résistance négligeable au courant, comparée à celle du matériau du détecteur.

Ils doivent donc être de type ohmique c'est-à-dire avoir une caractéristique courant-tension quasiment linéaire et mettre à profit une courbure de bande judicieuse au contact métal-semi-conducteur, un effet tunnel à cet endroit et les recombinaisons dans la zone de charge d'espace.

La réalisation de tels contacts ohmiques sur les matériaux cités plus haut (II-VI) reste un problème délicat à résoudre car, outre le comportement électrique convenable qu'il faut obtenir, ces électrodes doivent être connectées par exemple à un circuit de lecture.

La connexion ne doit en aucun cas modifier le comportement électrique du contact. Elle induit en général des contraintes que le contact doit pouvoir accepter. Son adhésion est donc capitale d'autant plus que les matériaux en présence n'ont pas nécessairement les mêmes coefficients de dilatation. Les variations de température induisent par conséquent des contraintes supplémentaires qui peuvent être très importantes.

Précisons dès maintenant que l'invention peut être mise en oeuvre avec des composés à base de Cd et de Te, de type p ou de type n.

Dans le cas de CdTe et des composés de ce dernier ayant une haute résistivité, il est difficile d'élaborer un contact ohmique car la plupart des métaux possèdent un travail d'extraction inférieur à celui du CdTe, qui est égal à 5,02 eV.

Seuls le platine (5,3eV) et l'or (4,8 eV) s'en approchent. Les contacts réalisés par évaporation ou pulvérisation de ces deux métaux ne sont ni ohmiques ni bloquants mais se situent entre les deux. D'autres phénomènes physico-chimiques, tels que les états de surface avant dépôt du métal ou l'oxydation de la surface, fixent la hauteur de barrière de potentiel indépendamment du travail d'extraction du métal.

L'obtention d'un contact ohmique est possible si les porteurs peuvent circuler librement par effet tunnel. Ce mode de transport est favorisé par le dépôt électrochimique de solutions de type chlorure d'or (AuCl₃) ou chlorure ou platine (PtCl₄) sur une surface préalablement décapée chimiquement. Le métal est réduit chimiquement par le tellure et agit comme un fort dopant accepteur à la surface du détecteur. A ce sujet, on se reportera au document suivant :
[1] J.P Ponpon, Solid-state electronics, vol. 28, n°7, pp. 689-706, 1985.

Comme on le voit, l'or et le platine sont parmi les meilleurs candidats pour la réalisation de contacts ohmiques de haute résistivité sur CdTe et sur les composés de ce dernier. Leur dépôt se fait préférentiellement par voie électrochimique (pour favoriser l'effet tunnel), sur une surface préalablement préparée convenablement.

A ce sujet, on se reportera au document suivant :
[2] E. Janick et al., J. Phys. D : Appl. Phys., 16 (1983), pp. 2333-2340.

Précisons que le CdTe ou les composés de celui-ci sont utilisés sous forme polycristalline ou monocristalline et sont de type n ou p.

De plus, la structure de ces matériaux induit une polarité : la stoechiométrie est différente suivant la face considérée. On conçoit que cette polarité induise un comportement mécanique et chimique spécifique selon le cas considéré.

La mise du détecteur aux dimensions souhaitées se fait en général par découpe, rodage puis polissage, ce qui permet d'obtenir des surfaces dont l'épaisseur perturbée est minime et pourra être enlevée par attaque chimique sans trop modifier la planéité et les dimensions finales, car cette épaisseur peut contenir des contaminants gênants du point de vue électrique et accroître la résistance à l'interface entre le matériau du détecteur et un contact électrique ultérieurement formé sur ce dernier.

Deux types de solutions sont généralement utilisés pour la préparation chimique de la surface :
- des solutions acides à base de bichromate de potassium ou d'un mélange de divers acides tels que HF, HNO₃, H₂SO₄, CH₃COOH ;
- des solutions mixtes acide/solvant, telles que la solution Br-méthanol, très utilisée dans le cas de CdTe ou d'un composé de ce dernier.

On connaît un grand nombre de solutions. Leur effet sur la stoechiométrie de surface peut différer d'une solution à l'autre, en particulier en ce qui concerne l'adhésion d'une couche métallique, destinée à constituer un contact électrique, et en ce qui concerne le comportement électrique du détecteur, après achèvement de ce dernier.

L'or et le platine sont bien adaptés à la formation d'électrodes, en particulier dans le cas de CdTe et des composés de ce dernier. Déposé par voie électrochimique (« electroless »), à partir d'un chlorure du métal considéré (l'or ou le platine), ce métal prend la place du cadmium à la surface du détecteur. Le cadmium, quant à lui, enrichit la solution servant au dépôt du métal.

Cette solution est en général constituée de chlorure d'or ou de platine et d'eau ou éventuellement d'un solvant, tel que l'éthylène-glycol par exemple.

L'épaisseur maximale obtenue dépend de la concentration en chlorure dans la solution mais est généralement inférieure à 150 nm pour Au et Pt, à cause de l'effet de polarisation qui est induit par la réaction de dépôt du métal (Au ou Pt).

Les contacts formés en or ou en platine par dépôt électrochimique (« electroless ») sur CdTe ou sur des composés de CdTe doivent répondre à
- des spécifications électriques car il doit y avoir une faible résistance à l'interface métal/semi-conducteur pour pouvoir collecter le maximum de charges du détecteur ;
- des spécifications mécaniques car il doit y avoir une épaisseur de contact suffisante, pour que la connexion ultérieure à un autre élément ne détériore pas le matériau sous-jacent ni les caractéristiques de celui-ci, et une adhésion suffisante pour accepter des contraintes mécaniques dues aux coefficients de dilatation différentes.

En effet, étant donné que la conductivité de CdTe est très faible, toute variation de température induit des contraintes dans le contact électrique.

De plus, dans le dépôt électrochimique (« electroless ») lui-même, les contraintes augmentent avec l'épaisseur de la couche, ce qui oblige à limiter cette épaisseur à 50 nm, d'où des risques de détérioration de l'interface métal/semi-conducteur au moment de la connexion.

Des contraintes sont également induites par un éventuel dépôt supplémentaire sur le contact (par exemple un dépôt de colle conductrice) ou par une soudure (avec un matériau différent, par exemple l'indium pour les connexions collectives de type retournement de puce (« flip chip »)) et donc une élévation de température (environ 160°C pour l'indium) avec création d'un alliage.

En outre, des contraintes sont induites sur le contact par l'assemblage avec un circuit de connexion ou un circuit de lecture dans un boîtier.

L'adhésion du contact est donc fonction de la préparation de surface, des réactions chimiques à l'interface métal/semi-conducteur, de l'épaisseur du dépôt mais aussi de la surface de ce dernier.

Or, la tendance actuelle, par exemple dans le domaine de la détection nucléaire, est de fabriquer des détecteurs monolithiques pixellisés ou de juxtaposer des détecteurs unitaires. La surface des contacts peut alors diminuer de 5mm² à 50µm². L'adhésion devient alors très critique.

L'adhésion des contacts est actuellement considérée comme un problème important. A ce sujet, on se reportera au document suivant :
[3] V. Gostilo et al., Nucl. Instr. and Meth. in Phys. Res. A 460 (2001), pp. 27-34.

En effet, une couche d'or déposée à partir d'une solution aqueuse (respectivement à partir d'une solution dans un solvant tel que l'éthylène-glycol) résiste à une force de décollage ne dépassant pas 1 kg/cm² (respectivement 2 kg/cm²) pour une couche dont l'épaisseur est inférieure à 50 nm. Pour des épaisseurs supérieures, l'adhésion diminue fortement.

En ce qui concerne le platine, lorsqu'il est déposé à partir d'une solution aqueuse à 30°C, l'adhésion est un peu meilleure mais chute fortement si l'épaisseur dépasse 100 nm.

Le document FR1143213 décrit le dépot électrochimique d'un métal sur un matériau II-VI à partir d'une solution d'un sel de métal précieux acidifiée ou non, présentant jusqu'à 20% de HCl.

### EXPOSÉ DE L'INVENTION

Le procédé objet de l'invention a pour but de former, sur un matériau de type CdTe ou sur des composés de ce matériau, des électrodes qui présentent de bonnes qualités électriques mais surtout une épaisseur et une capacité d'adhésion importantes. Pour ce faire, on procède à un dépôt électrochimique (« electroless ») de chlorure d'or ou de platine en solution dans l'acide chlorhydrique pur.

Avantageusement, une préparation de la surface du matériau utilisé (CdTe ou un composé de CdTe) est réalisée à partir d'une solution de Br et d'acide chlorhydrique de préférence pur.

Plus généralement, la présente invention résout le problème de la fabrication d'électrodes sur un matériau semi-conducteur de type II-VI, ou sur un composé de ce matériau, ces électrodes étant susceptibles d'avoir une plus grande épaisseur et une meilleure adhésion sur le matériau que dans l'art antérieur.

De façon précise, la présente invention a pour objet un procédé de fabrication d'au moins une électrode sur un matériau semi-conducteur II-VI ou un composé de ce matériau, cette électrode étant en un métal dont le travail d'extraction est sensiblement égal ou supérieur à celui du semi-conducteur II-VI, ce procédé étant caractérisé en ce que l'électrode est formée par un dépôt électrochimique du métal à partir d'une solution d'un chlorure du métal dans l'acide chlorhydrique pur.

De préférence, le métal est l'or ou le platine et l'on utilise une solution de chlorure d'or ou de platine dans l'acide chlorhydrique pur.

En outre, de préférence, la concentration du chlorure d'or ou de platine dans l'acide chlorhydrique pur est inférieure à 5 %.

Selon un mode de mise en oeuvre préféré de l'invention, on prépare la surface du matériau avant le dépôt pour rendre cette surface apte à la fixation du métal.

Pour ce faire, la surface de matériau peut être décapée chimiquement.

Dans ce cas, selon un mode de réalisation particulier, le métal étant l'or ou le platine, on utilise une solution de chlorure d'or ou de platine dans l'acide chlorhydrique pur et l'on utilise une solution de brome et d'acide chlorhydrique de préférence pur pour le décapage chimique.

De préférence, le matériau est CdTe. Dans ce cas, on peut par exemple former l'électrode sur un matériau qui est choisi parmi CdZnTe, CdTe:Cl, CdTeSe:Cl, CdZnTe:Cl, CdTe:In, CdZnTe:In et CdHgTe.

### EXPOSÉ DÉTAILLÉ DE MODES DE RÉALISATION PARTICULIERS

L'invention permet par exemple la réalisation de couches d'or ou de platine dont l'épaisseur est comprise entre 100 nm et 150 nm et qui résistent à des forces de décollage supérieures à 10 kg/cm², grâce à une préparation chimique convenable de la surface du CdTe ou d'un composé de ce dernier, suivie du dépôt électrochimique ("electroless") du métal à partir d'une solution acide.

Plus précisément, la préparation chimique de la surface consiste à enlever l'épaisseur endommagée par l'usinage (rodage, polissage) et à créer une surface à laquelle un futur dépôt est capable d'adhérer et qui est chimiquement favorable à l'obtention d'une interface métal/semi-conducteur de faible résistance et cette préparation est réalisée à partir d'une solution composée de Br et d'acide chlorhydrique de préférence pur dans une proportion convenable (quelques % de Br).

La dissolution de Br dans l'acide chlorhydrique de préférence pur est très lente et exige une agitation de plusieurs minutes.

Après l'attaque chimique, l'échantillon est rincé dans l'acide chlorhydrique de préférence pur (par exemple deux fois) puis séché directement. La mise en présence d'eau est déconseillée.

L'échantillon correctement séché est ensuite mis en contact avec la solution électrochimique ("electroless") dont la caractéristique essentielle est que le chlorure d'or ou de platine est dissout dans l'acide chlorhydrique pur.

La concentration du chlorure est de préférence faible (moins de 1 % dans le cas du chlorure d'or) car la cinétique de dépôt est importante pour le résultat final.

Lorsque le dépôt est terminé, un rinçage est fait dans l'acide chlorhydrique puis dans l'eau, suivi d'un séchage convenable.

L'ensemble de ce procédé est mis en oeuvre en milieu acide, ce qui conduit à protéger les parties de l'échantillon, qui ne doivent pas subir une attaque chimique ou recevoir le dépôt métallique, avec des résines photosensibles positives qui sont classiquement utilisées dans l'industrie des semi-conducteurs.

Ces résines photosensibles positives sont solubles dans les solvants standard comme par exemple le méthanol. Or, la préparation chimique d'une surface est très souvent effectuée avec un mélange Br-méthanol.

De surcroît, le dépôt d'or est aussi parfois réalisé en présence d'un solvant.

En outre, la tension superficielle des deux solutions (l'une pour la préparation et l'autre pour le dépôt) est telle qu'elle permet l'utilisation de gouttes de ces solutions et donc des attaques chimiques et des dépôts qui sont limités aux surfaces destinées au contact.

Ces opérations sont irréalisables avec le mélange Br-méthanol ou avec des solutions de chlorure dans un solvant, tel que l'héthylène-glycol par exemple.

Rappelons aussi que le chlore est utilisé comme dopant dans les matériaux semi-conducteurs, le milieu contenant du chlore étant ainsi favorable à de tels matériaux.

Des essais comparatifs réalisés sur le même matériau (CdTe) mais avec des technologies de contact différentes montrent que l'efficacité de détection des détecteurs réalisés avec ce procédé est au moins égale à celle des détecteurs réalisés avec des technologies classiques.

De plus, la durée d'utilisation de la solution de Br dans l'acide chlorhydrique est longue (plusieurs jours) alors que les solutions Br-méthanol classiques ne conservent leur agressivité que pendant quelques heures à cause de l'évaporation du brome.

En outre, la concentration par exemple de l'or dans la solution de dépôt est très inférieure à celle des solutions aqueuses classiques (1 g pour 30 cm³ d'eau), ce qui est intéressant du point de vue industriel.

On a mis en oeuvre ce procédé sur des détecteurs unitaires en CdTe (HPBM) ou en CdTe:Cl (de type p) et aussi sur des détecteurs monolithiques pixellisés. Leur comportement électrique montre une amélioration sensible et, du point de vue mécanique, une adhésion très élevée.

On donne ci-après un autre exemple du procédé objet de l'invention, permettant de fabriquer des électrodes en or sur un substrat de CdTe.

Pour ce faire, on utilise une solution de chlorure d'or dans l'acide chlorhydrique pur, la concentration du chlorure d'or dans cet acide étant inférieure à 1%.

On procède alors au dépôt électrochimique de l'or sur les zones du substrat où l'on veut former les électrodes, en mettant la solution en contact avec ces zones.

Au préalable, on protège les parties du substrat que l'on ne veut pas mettre en contact avec la solution, en particulier les parties sur lesquelles on ne veut pas déposer de l'or. Pour ce faire, on forme un revêtement protecteur sur ces parties et l'on élimine ce revêtement après avoir déposé l'or aux endroits souhaités.

En tant que revêtement protecteur, on peut par exemple utiliser une couche de résine photosensible.

En outre, il est préférable de préparer la surface du substrat avant d'y déposer l'or, notamment pour rendre cette surface apte à fixer l'or.

Pour ce faire, on peut procéder à un décapage chimique de cette surface au moyen d'une solution de brome dans l'acide chlorhydrique de préférence pur. De préférence, on rince au moyen du même acide puis d'eau la surface ainsi décapée puis on sèche cette dernière.

Comme on l'a vu plus haut, on peut utiliser le platine au lieu de l'or.

Au lieu d'un substrat en CdTe, on peut utiliser un substrat fait d'un composé de CdTe pour y former des électrodes conformément à l'invention. Des exemples d'un tel composé ont déjà été donnés plus haut.

On rappelle ci-après ce qu'est l'acide chlorhydrique pur.

L'acide chlorhydrique est un liquide que l'on obtient par dissolution du chlorure d'hydrogène (gaz de formule chimique HCl) dans l'eau. Au maximum, on peut dissoudre 37% (à 38%) en poids de molécules de gaz HCl dans l'eau. Pour cette concentration maximale, on parle d'acide chlorhydrique « pur ». C'est ce liquide qui est utilisé dans la présente invention pour le dépôt électrochimique.

Il convient de noter que dans l'art antérieur (voir par exemple FR 1 143 213 A) on utilise une solution d'acide chlorhydrique concentrée entre 0% et 20%. Cela signifie que, pour obtenir une telle solution, l'acide pur a été dilué et que la concentration de la solution est comprise entre 0% de 37% et 20% de 37% de HCl gazeux.

## Revendications

1. Procédé de fabrication d'au moins une électrode sur un matériau semi-conducteur II-VI ou un composé de ce matériau, cette électrode étant en un métal dont le travail d'extraction est sensiblement égal ou supérieur à celui du semi-conducteur II-VI, ce procédé étant **caractérisé en ce que** l'électrode est formée par un dépôt électrochimique du métal à partir d'une solution d'un chlorure du métal dans l'acide chlorhydrique pur.

2. Procédé selon la revendication 1, dans lequel le métal est l'or ou le platine et l'on utilise une solution de chlorure d'or ou de platine dans l'acide chlorhydrique pur.

3. Procédé selon la revendication 2, dans lequel la concentration du chlorure d'or ou de platine dans l'acide chlorhydrique pur est inférieure à 5 %.

4. Procédé selon l'une quelconque des revendications 1 à 3, dans lequel on prépare la surface du matériau avant le dépôt pour rendre cette surface apte à la fixation du métal.

5. Procédé selon la revendication 4, dans lequel la surface du matériau est décapée chimiquement.

6. Procédé selon la revendication 5, dans lequel le métal est l'or ou le platine, on utilise une solution de chlorure d'or ou de platine dans l'acide chlorhydrique pur et l'on utilise une solution de brome et d'acide chlorhydrique de préférence pur pour le décapage chimique.

7. Procédé selon l'une quelconque des revendications 1 à 6, dans lequel le matériau est CdTe.

8. Procédé selon la revendication 7, dans lequel on forme l'électrode sur un matériau qui est choisi parmi CdZnTe, CdTe:Cl, CdTeSe:Cl, CdZnTe:Cl, CdTe:In, CdZnTe:In et CdHgTe.

## Patentansprüche

1. Verfahren zur Herstellung mindestens einer Elektrode auf einem II-VI Halbleiter-Material oder einer Verbindung dieses Materials, wobei diese Elektrode aus einem Metall besteht, dessen Elektronen-Austrittsarbeit im Wesentlichen gleich oder größer ist als diejenige des II-VI-Halbleiters,
**dadurch gekennzeichnet, dass** die Elektrode durch elektrochemische Abscheidung des Metalls aus einer Lösung eines Chlorids des Metalls in reiner Chlorwasserstoffsäure gebildet wird.

2. Verfahren nach Anspruch 1, in dem das Metall Gold oder Platin ist und eine Lösung von Goldchlorid oder Platinchlorid in reiner Chlorwasserstoffsäure verwendet wird.

3. Verfahren nach Anspruch 2, in dem die Konzentration des Goldchlorids oder Platinchlorids in reiner Chlorwasserstoffsäure unter 5 % liegt.

4. Verfahren nach einem der Ansprüche 1 bis 3, bei dem diese Oberfläche des Materials vor der Abscheidung vorbehandelt wird, um eine Fixierung des Metalls daran zu ermöglichen.

5. Verfahren nach Anspruch 4, bei dem die Oberfläche des Materials chemisch gebeizt wird.

6. Verfahren nach Anspruch 5, in dem das Metall Gold oder Platin ist und eine Lösung von Goldchlorid oder Platinchlorid in reiner Chlorwasserstoffsäure verwendet wird und eine Lösung von Brom und vorzugsweise reiner Chlorwasserstoffsäure für das chemische Beizen verwendet wird.

7. Verfahren nach einem der Ansprüche 1 bis 6, in dem das Material CdTe ist.

8. Verfahren nach Anspruch 7, bei dem die Elektrode auf einem Material gebildet wird, das ausgewählt wird aus der Gruppe CdZnTe, CdTe:Cl, CdTeSe:Cl, CdZnTe:Cl, CdTe:ln, CdZnTe:ln und CdHgTe.

## Claims

1. A method for manufacturing at least one electrode on a II-VI semiconducting material or a compound of this material, this electrode being in a metal for which the work function is substantially equal to or larger than that of the II-VI semiconductor, this method being **characterized in that** the electrode is formed by electrochemical deposition of the metal from a solution of a chloride of the metal in pure hydrochloric acid.

2. The method according to claim 1, wherein the metal is gold or platinum and a gold or platinum chloride solution in pure hydrochloric acid is used.

3. The method according to claim 2, wherein the concentration of gold or platinum chloride in pure hydrochloric acid is less than 5%.

4. The method according to any of claims 1 to 3, wherein the surface of the material is prepared before the deposition in order to make this surface capable of fixing the metal.

5. The method according to claim 4, wherein the surface of the material is chemically etched.

6. The method according to claim 5, wherein the metal is gold or platinum, a gold or platinum chloride solution in pure hydrochloric acid is used and a solution of bromine and preferably pure hydrochloric acid is used for the chemical etching.

7. The method according to any of claims 1 to 6, wherein the material is CdTe.

8. The method according to claim 7, wherein the electrode is formed on a material which is selected from CdZnTe, CdTe:Cl, CdTeSe:Cl, CdZnTe:Cl, CdTe:In, CdZnTe:In and CdHgTe.
